# EUROPEAN PATENT APPLICATION

(11) **EP 4 815 310 A1**
(43) Date of publication of application: **30.09.2026**
(21) Application number: 26166595.4
(22) Date of filing: 23.03.2026
(51) Int. Cl.: H03K 19/00

(54) **SYSTEM ON CHIP**

(30) Priority: 25.03.2025 FR 2503044
(71) Applicant: STMicroelectronics International N.V., 1228 Plan-les-Ouates, Geneva (CH)
(72) Inventor: CONDORELLI, Riccardo, 95030 TREMESTIERI ETNEO / CATANIA (IT); MONDELLO, Antonino, 98148 MESSINA (IT); CARRANO, Michele Alessandro, 95129 CATANIA (IT)
(74) Representative: Cabinet Beaumont

(57) **Abstract**

The present disclosure relates to a system on chip (100), comprising a controller (300) and one or several input/output circuits (108a, 108b, 108c), each of said circuits having:
- a first stage (214) and a second stage (212) operatively coupled to each other;
- said first stage (214) being configured to be powered by a first voltage (V33); and
- said second stage (212) being configured to be, controllably by the controller (300), powered by a second voltage (V11, V11 R1, V11 R2) different from first voltage (V33).

## Description

### Technical field

The present disclosure relates generally to systems on chip.

### Background art

Systems on chip comprise often input/output (I/O) circuits to apply digital or analogic signals on output pins, or to sense signals present on input pins.

These input/output (I/O) circuits are causing power leaks which are too important for a low power functioning.

### Summary of Invention

There is a need to reduce the power leaks caused by the input/output (I/O) circuits.

One embodiment addresses all or some of the drawbacks of known systems on chip.

One embodiment provides a system on chip, comprising a controller and one or several input/output circuits, each of said circuits having:
- a first stage and a second stage operatively coupled to each other;
- said first stage being configured to be powered by a first voltage; and
- said second stage being configured to be, controllably by the controller, powered by a second voltage different from first voltage.

According to one embodiment, said first stage is configured to control at least one output pin of the respective input/output circuit according to a first signal state present on a first input of the second stage.

According to one embodiment, said second stage comprises a least one digital logic block.

According to one embodiment, said second stage is configured to be coupled to at least one functionality block of the system on chip.

According to one embodiment, the system on chip comprises at least one voltage regulator configured to generate the second voltage from the first voltage.

According to one embodiment, said one or several input/output circuits comprise, each, a first switch coupling a respective node of application of the second voltage to the second stage of the respective input/output circuit;
each first switch being configured to be controlled according to a respective input/output signal generated by the controller.

According to one embodiment, the system on chip comprises at least one second switch per said one or several input/output circuits, each second switch coupling a respective node of application of the second voltage to the second stage of the respective input/output circuit;
each second switch being configured to be controlled respectively by the controller.

According to one embodiment, the system on chip comprises one second switch per group of said one or several input/output circuits;
said second switch coupling a node of application of the second voltage to a node common to the second stages of the input/output circuits of the group.

According to one embodiment, the input/output circuits of said group participate to a same functionality, for example a bus communication functionality.

According to one embodiment, the second stage of each of said one or several input/output circuits comprises a second input, each second input of each of the input/output circuits being coupled, by a different conduction path, to the controller ;
each of said one or several input/output circuits being configured to insulate a rail of application of the first voltage from its respective output pin, and to ground the respective output pin, based on a respective second signal state present on the second input;
the controller being configured to control the said second signal state respectively for each of said one or several input/output circuits.

According to one embodiment, the second stage of said one or several input/output circuits comprises a second input coupled to the controller;
each of said one or several input/output circuits of the group being configured to insulate a rail of application of the first voltage from its respective output pin, and to ground the respective output pin, based on a respective second signal state present on their second input and common to all input/output circuits of the group;
the controller being configured to control the said second signal state respectively for each different group of said one or several input/output circuits.

According to one embodiment, each first switch is configured to be controlled based on the respective second signal state present on the second input of the respective input/output circuit.

According to one embodiment, said second switch per group of input/output circuits is configured to be controlled based on the second signal state present on the second inputs of the input/output circuits of said respective group.

According to one embodiment, the controller is configured to control a state of each of the first or second switches according to a content of a configuration register.

According to one embodiment, respective connection elements couple each of said nodes of application of the second voltage to a first and to a second rail ;
a state of each connection element defining which of the nodes of application of the second voltage are conductively coupled to the first rail and which of the nodes of application of the second voltage are conductively coupled to the second rail;
said first and second rails being configured to receive respectively a voltage, equal or similar to the second voltage, from different circuits.

According to one embodiment, said connection elements are switches controlled by said controller.

According to one embodiment, said connection elements are metal level parts, the presence or the absence of said metal level parts defining which of the nodes of application of the second voltage are conductively coupled to the first rail and which of the nodes of application of the second voltage are conductively coupled to the second rail.

According to one embodiment, said connection elements are fuses, the fusing state of said fuses defining which of the nodes of application of the second voltage are conductively coupled to the first rail and which of the nodes of application of the second voltage are conductively coupled to the second rail.

One embodiment provides a device comprising a system on chip as described above.

### Brief description of drawings

The foregoing features and advantages, as well as others, will be described in detail in the following description of specific embodiments given by way of illustration and not limitation with reference to the accompanying drawings, in which:
Figure 1 illustrates very schematically, in form of functional blocks, an example of a system on chip on which the described embodiments apply;
Figure 2 represents different blocks of Figure 1 according to an example;
Figure 3 represents different blocks of Figure 1 according to an embodiment;
Figure 4 represents different blocks of Figure 1 according to another embodiment;
Figure 5 represents different blocks of Figure 1 according to an embodiment;
Figure 6 represents different blocks of Figure 1 according to an embodiment;
Figure 7a illustrates schematically blocks of Figure 1 according to an embodiment;
Figure 7b illustrates schematically blocks of Figure 1 according to an embodiment; and
Figure 8 illustrates schematically blocks of Figure 1 according to an embodiment.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 % or 10°, and preferably within 5 % or 5°.

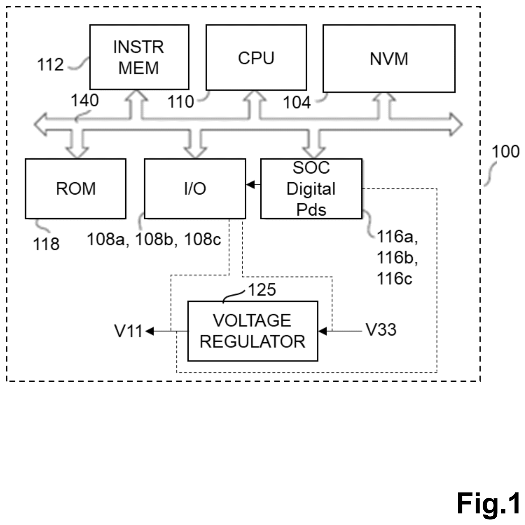

Figure 1 illustrates very schematically, in form of functional blocks, an example of a system on chip 100 on which the described embodiments apply.

System on chip 100 comprises for example a non-volatile memory 104 (NVM), for example of phase-change type, capable of communicating, via a communication bus, with a non-illustrated non-volatile memory interface configured to write or read data into and from non-volatile memory 104.

System on chip 100 further comprises, for example, a processing unit 110 (CPU) comprising one or a plurality of processors under control of instructions stored in an instruction memory 112 (INSTR MEM). Instruction memory 112 is, for example, a volatile random-access memory (RAM). Processing unit 110 and memory 112 communicate, for example, via a system (data, address, and control) bus 140. Memory 104 is coupled to system bus 140 via the non-volatile memory interface and a bus.

System on chip 100 comprises for example a read-only or static memory 118 (ROM) coupled to bus 140.

System on chip 100 further comprises an input/output function block 108 (I/O) coupled for example to system bus 140 to communicate with other blocks. The input/output block 108 comprises for example several, for example up to ten or more, input/output circuits (also called pads) 108a, 108b, 108c. Each of the input/output circuits 108a, 108b, 108c comprises for example a first stage coupled to one or several output (respectively input) pins, and for example a second stage which is coupled operatively to the first stage. In other words, in an example, the first stage receives logic or analogic signals from the second stage. In another example, the analogic or digital signal received on an input/output pin of an input/output circuit 108a, 108b, 108c, is processed through the first stage and is sent to the second stage to be leveled-up. The second stage comprises for example digital circuits or digital cells.

System on chip 100 may integrate other circuits implementing other functions, symbolized by functional blocks 116a, 116b, 116c (SOC Digital Pds) in Figure 1, comprising for example N digital blocks 116a, 116b, 116c configured to perform digital operations, N being an integer.

System on chip 100 comprises for example a voltage regulator 125, for example a low dropout circuit (LDO) or a switch mode power supply (SMPS). The voltage regulator 125 for example has an input coupled, preferably connected, to a rail of application a first voltage called V33 and has an output coupled, preferably connected, to a rail of application a second voltage called V11. In an example, the first voltage V33 is comprised between 1.5V and for example 5V, for example around 3.3V. In an example, the regulated second voltage V11 is comprised between 0.5 and 1.4V, for example around 1.2V.

In an example, the second voltage V11 is obtained by another circuit than a voltage regulator.

In an example, the N digital blocks 116a, 116b, 116c are powered, for example in a controlled manner, by the second voltage V11.

In an example, the input/output circuits 108a, 108b, 108c are coupled to the rail of application of the first voltage V33 and to the rail of application of the second voltage V11.

In the represented example, the blocks 116a, 116b, 116c are coupled, for example via buses, to the input/output circuits 108a, 108b, 108c.

In an example, all or only some of the functional blocks shown in Figure 1 are for example integrated in a microcontroller.

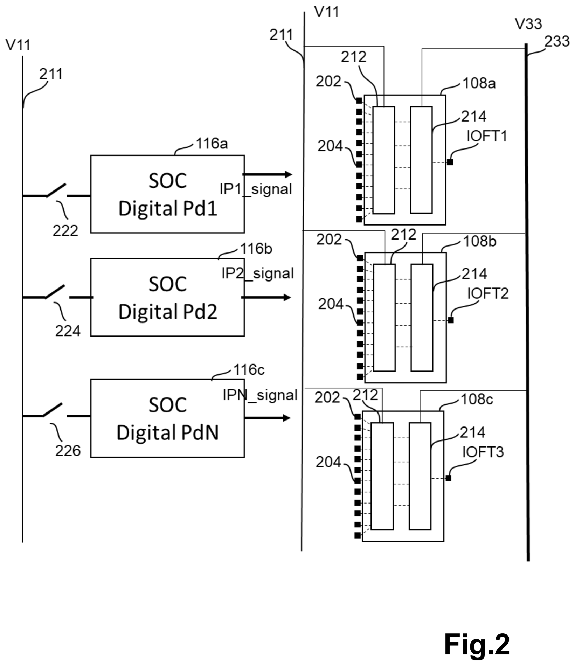

Figure 2 represents different blocks of Figure 1 according to an example.

More particularly, the example of Figure 2 represents an example with three input/output circuits 108a, 108b, 108c which are coupled respectively to a digital block 116a (SOC Digital Pd1), a digital block 116b (SOC Digital Pd2), and a digital block 116c (SOC Digital PdN). In other examples, the number of digital blocks and input/output circuits can be ranging from one to ten or even up to one hundred for example.

In the represented example, a switch 222 couples the digital block 116a to the rail of application of the second voltage V11, a switch 224 couples the digital block 116b (SOC Digital Pd2) to the rail 211 of application of the second voltage V11, and a switch 226 couples the digital block 116c (SOC Digital PdN) to the rail 211 of application of the second voltage V11.

In the represented example, the switches 222, 224 and 226 are controlled by respective signals coming for example from the processing unit 110 or a non-illustrated specific controller.

In an example, several of the input/output circuits 108a, 108b, 108c, address a similar functionality, for example a bus communication functionality. In other words, several of the input/output circuits 108a, 108b, 108c, may be achieving a different part of a same similar global functionality.

In the example of Figure 2, each of the input/output circuits 108a, 108b, 108c comprises a first and a second stage 214, 212. The second stage 212 of each of the input/output circuits 108a, 108b, 108c comprises for example inputs 202, 204 which number can vary from one to one hundred for example.

In the represented example, the respective first stage 214 of the circuits 108a, 108b, 108c is coupled, preferably connected, to a respective output (respectively input) pin IOFT1, IOFT2, IOFT3. The output pins IOFT1, IOFT2, IOFT3 are for example wire bonded to external pads.

In the represented example, the first stage 214 is coupled to, otherwise said powered by, the rail of application of the first voltage V33. The first voltage V33 is used to communicate, at higher voltages than the second voltage, with the respective external pins IOFT1, IOFT2, IOFT3. Otherwise said, the first stage is configured to be powered by the first voltage V33. In other words, one or several nodes of the first stage 214 are coupled to the rail 233 of application of the first voltage V33.

In the represented example, the second stage is coupled to the rail of application of the second voltage V11. The second voltage V11 is used to interface with the internal controls of the system on chip, for example the blocks 116a, 116b, 116c. Otherwise said, the second stage 212 is configured to be powered by the second voltage V11. In other words, one node or several nodes of the second stage 212 are coupled, preferably connected, to the rail 211 of application of the second voltage V11.

In an example, one or several nodes of the first and/or second stage 214, 212 are coupled to ground.

In an example, the second stage 212 of the circuits 108a, 108b, 108c comprises a digital logic rule circuit related to a display driver.

In an example, the second stage 212 of the circuits 108a, 108b, 108c comprises a digital logic circuit related to the processing of internal signals coming for example from the processing unit 110, for example pull-up or pull-down signals.

In an example, the first stage 214 and/or the second stage 212 of the circuits 108a, 108b, 108c comprises digital to analogic or analogic to digital functions.

In an example, the first stage 214 serves as an output buffer.

In an example, the first stage 214 is a part of the second stage 212 which is coupled, preferably connected, to the first voltage V33.

In an example, the first and second stages 214, 212 form together for example a single circuit with a part, which is the first stage, coupled, preferably connected, to the rail 233 of application the first voltage V33, and another part, which is the second stage 212, coupled, preferably connected, to the rail 211 of application the second voltage V11.

In an example, the second stage 212 reacts according to signals IP1_signal, IP2_signal, IPN_signal, for example originating from the respective digital circuits 116a, 116b, 116c, and which are provided on dedicated inputs of the second stage 212, for example the input 202 or any of the inputs of the second stage 212. The second stage 212 outputs for example signals toward the first stage 214 which for example levels these signals up using the first voltage V33.

In the example of Figure 2, each blocks 116a, 116b, 116c can be disconnected, using the respective switch 222, 224, 226, from the rail of application of second voltage V11 according to the powering strategy. Nevertheless, the input/output circuits 108a, 108b, 108c, are always kept connected to the rails of application of the first and second voltages V33, V11, whether they are in use or not. This leads to unnecessary power consumption, especially in low power modes which are critical for portable and Internet of Things applications. The constant leakage current associated with these voltage rails contributes to the overall power drain of the system on chip 100, impacting the battery life for example and overall efficiency.

In order to overcome these issues, the described embodiments provide a system on chip, comprising a controller and one or several input/output circuits, each of said circuits having:
- a first stage and a second stage operatively coupled to each other;
- said first stage being configured to be powered by a first voltage; and
- said second stage being configured to be, controllably by the controller, powered by a second voltage different from first voltage.

The leakage consumption is therefore reduced by allowing the unnecessary part of the input/output circuits 108a, 108b, 108c to be disconnected, in a controllable manner, from the rail of application of the second voltage V11.

The described embodiments are compatible with existing solutions.

Only input/output circuits needed can be kept powered in a controllable manner in order to address low power applications.

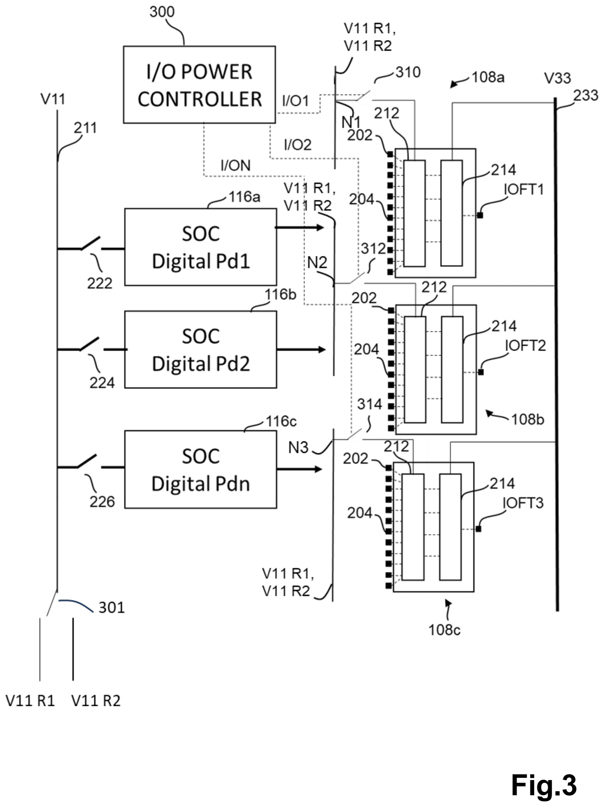

Figure 3 represents different blocks of Figure 1 according to an embodiment.

The example of Figure 3 is similar to the example of Figure 2 except that each input/output circuit 108a, 108b, 108c comprises a respective switch 310, 312, 314, coupling its respective second stage 212 to a respective node N1, N2, N3.

In an example, the second voltage can come from two different power supplies or regulators. The respective second voltages coming each from a respective power supplies or regulator, have equal or similar values and are called in the text V11 R1 and V11 R2.

In another example, the output of the voltage regulator that generates the second voltage is coupled to a controlled power switch 301 and the second voltage outputting on two different output nodes of this switch 301 are called in the text V11 R1 and V11 R2.

In an example, V11 R2 voltage rail is a deeper low power mode (for example when most of the design is OFF). With this solution, the user can save power by selecting which circuit is strictly needed.

In an example, the nodes N1, N2, N3 are coupled, preferably connected, for example in a controllable manner, to either one or the other power supplies or regulators to receive either the second voltage V11 R1 or the voltage V11 R2.

In an example, nodes N1, N2, N3 are connected together to a single rail which receives the second voltage V11 similarly to the rail 211 of Figure 2.

In another example, nodes N1, N2, N3 are connected together to a single rail similarly to the rail 211 of Figure 2. In an example, this single rail is coupled, preferably connected, for example in a controllable manner, to either one or the other power supplies or regulators to receive either the second voltage V11 R1 or the voltage V11 R2.

The switches 310, 312, 314, are for example NMOS or PMOS transistors. The use of NMOS or PMOS transistors leads to a low switch consumption.

The switches 310, 312, 314, are for example controlled by respective signals I/O1, I/O2, I/ON, generated by a controller 300 (I/O POWER CONTROLLER) of the system on chip 100.

In an example, the controller 300 is the processing unit 110.

The example of Figure 3 allows a controllable disconnection or connection, independently, of each of the input/output circuits 108a, 108b, 108c, from or to, one of the rails of application of the second voltage V11 R1, V11 R2.

In the represented example, the respective second stages 212 of the input/output circuits 108a, 108b, 108c can be disconnected or connected, independently, from or to, the respective nodes N1, N2, N3 of application of the second voltage V11 R1, V11 R2, according to signals I/O1, I/O2 and I/ON (or their respective state).

In an example, the switches 310, 312, 314 are transistors for example NMOS or PMOS and, in order to open these switches, their respective control signal I/O1, I/O2, I/ON are for example set to a low level or zero in the case of NMOS, and set to high level in the case of PMOS. To close the switches 310, 312, 314, i.e. in order to render them in a conductive state, their respective control signal I/O1, I/O2, I/ON are for example set to a high level or Vdd in the case of NMOS, and set to low level in the case of PMOS.

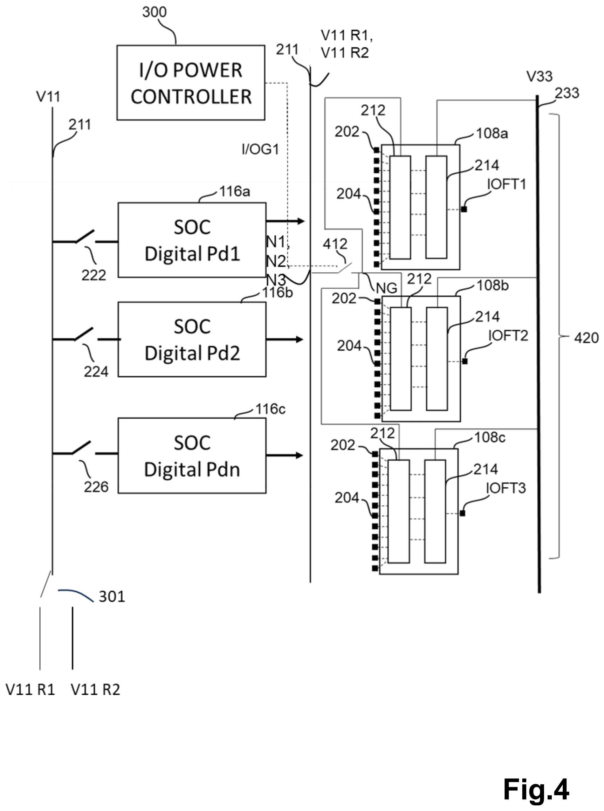

Figure 4 represents different blocks of Figure 1 according to another embodiment.

The example of Figure 4 is similar to the example of Figure 3 except that the respective second stages 212 of the input/output circuits 108a, 108b, 108c do not comprise, in this case, a respective switch. Instead, the respective second stages 212 of the input/output circuits 108a, 108b, 108c are coupled, preferably connected, to a same node NG. In the represented example, the system on chip 100 comprises a single switch 412 which couples the node NG to the nodes N1, N2, N3 which are, in this example, connected together and to a single rail similar to rail 211. This single rail is coupled, preferably connected, for example in a controllable manner, to either one or the other power supplies or regulators to receive either the second voltage V11 R1 or the voltage V11 R2. In other words, in this example, the switches are not comprised in each of the input/outputs circuits. The switch 412 is controlled by a signal I/OG1 generated by the controller 300.

In the represented example, the input/output circuits 108a, 108b, 108c form a group 420 and there is one switch 412 per group of input/output circuits 108a, 108b, 108c. Even it is not illustrated, other groups of other input/output circuits can be formed. In this case the respective second stages 212 of the input/output circuits of each group are coupled, preferably connected, together to the same node and this node is coupled to the rail 211 of application of the second voltage V11 R1, V11 R2 via a respective switch similar to switch 412 for example. In this case, each respective switch is controlled by a respective signal generated by the controller 300.

In an example, each group of input/output circuits 108a, 108b, 108c participate to a same global functionality, for example a bus communication functionality. In other words, each input/output circuits 108a, 108b, 108c of a group 420 can be dedicated to different parts of a global functionality.

The example of Figure 4 allows to group the input/output circuits 108a, 108b, 108c by functions which share a common supply strategy with common control and common power switch.

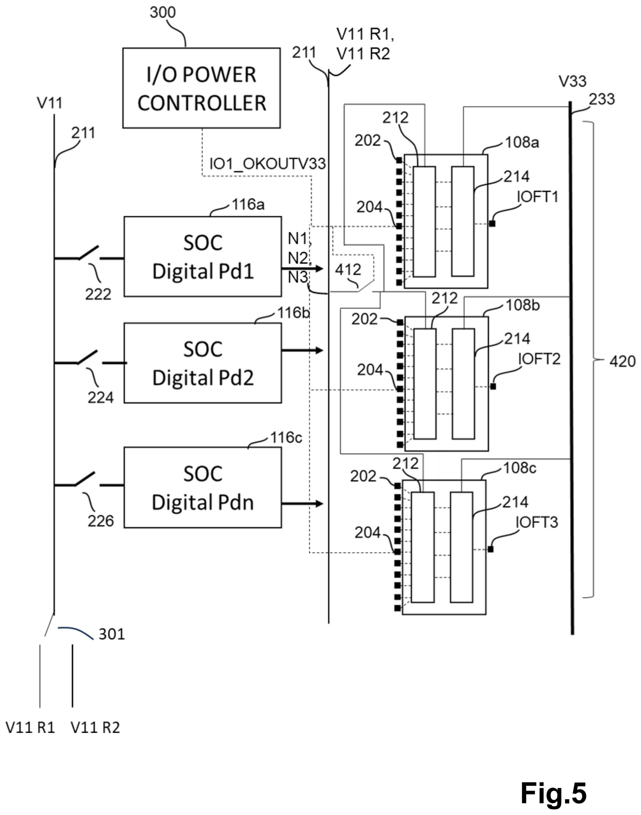

Figure 5 represents different blocks of Figure 1 according to an embodiment.

The example of Figure 5 is similar to the example of Figure 4 except that a signal IO1_OKOUTV33, for example similar to signal I/OG1, is generated by the controller 300 and controls the switch 412, and is also applied to the pin 204 of each of the input/output circuits of the group 420.

In an example, the input/output circuits 108a, 108b, 108c are configured to, when receiving the signal IO1_OKOUTV33, specifically on pin 204 for example, to insulate the rail of application of the first voltage V33 from their respective output pin IOFT1, IOFT2, IOFT3.

In an example, the input/output circuits 108a, 108b, 108c are configured to, when receiving the signal IO1_OKOUTV33, specifically on pin 204 for example, to ground their respective output pin IOFT1, IOFT2, IOFT3.

The example of Figure 5 allows a protection of the output of the first stages of the input/output circuits 108a, 108b, 108c against the first voltage V33. In other words, external circuits connected to the output pins are protected against the first voltage V33 when the respective input/output circuit 108a, 108b, 108c are disconnected from the rail 211 of application of the second voltage V11 R1, V11 R2.

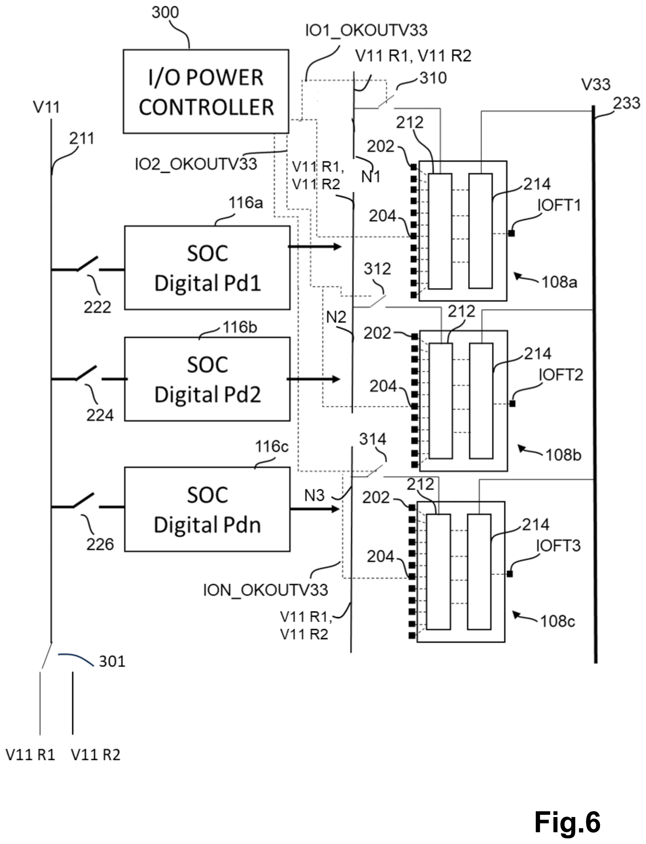

Figure 6 represents different blocks of Figure 1 according to an embodiment.

The example of Figure 6 is similar to the example of Figure 3 except that signals IO1_OKOUTV33, IO2_OKOUTV33, and ION_OKOUTV33, for example similar to signals I/O1, I/O2, I/O3, are applied respectively to the switches 310, 312 and 314, and also respectively to the input 204 of the input/output circuits 108a, 108b, 108c.

In an example, the input/output circuits 108a, 108b, 108c are configured to, when receiving the respective signal IO1_OKOUTV33, IO2_OKOUTV33, ION_OKOUTV33, specifically on a dedicated pin 204 for example, to insulate the rail 233 of application of the first voltage V33 from their respective output pin IOFT1, IOFT2, IOFT3.

In an example, the input/output circuits 108a, 108b, 108c are configured to, when receiving the respective signal IO1_OKOUTV33, IO2_OKOUTV33, or ION_OKOUTV33, specifically on pin 204 for example, to ground their respective output pin IOFT1, IOFT2, IOFT3.

The example of Figure 6 allows a protection of the output of the first stages 214 of the input/output circuits 108a, 108b, 108c against the first voltage V33. Moreover, in this example, it is possible to configure each power mode of each input/output circuit 108a, 108b, 108c.

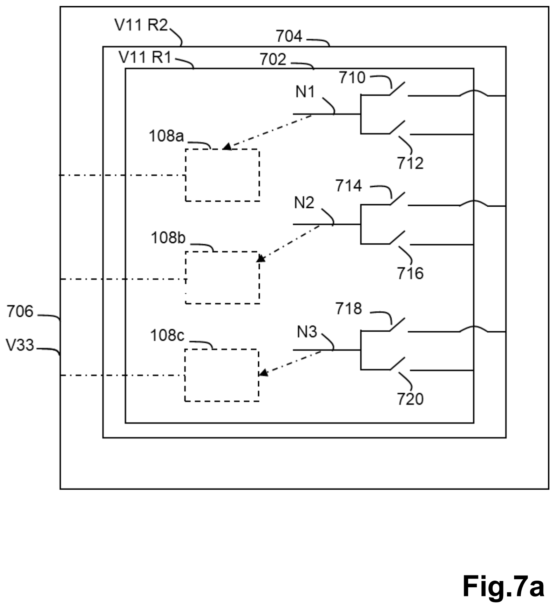

Figure 7a illustrates schematically blocks of Figure 1 according to an embodiment.

The example of Figure 7a applies to the examples of Figure 3 and 6 for example. In the example of Figure 7a, all of the input/output circuits 108a, 108b, 108c are surrounded by three rails 702, 704 and 706 of application of similar or different voltages. The rails 702, 704, 706 are for example buried in a silicon substrate where the input/output circuits 108a, 108b, 108c are formed. The rails 702 (V11 R1) and 704 (V11 R2) are configured to receive respectively the two voltages V11 R1, V11 R2, which are equal or similar to the second voltage V11, but coming from different power supplies or regulators for example. The rail 706 is for example configured to receive the first voltage V33.

In the represented example, a switch 712 couples the rail 702 to node N1, and a switch 710 couples the rail 704 to node N1. The switches 710 and 712 are for example controlled with opposite signals.

In the represented example, a switch 716 couples the rail 702 to node N2 and a switch 714 couples the rail 704 to node N2. The switches 714 and 716 are for example controlled with opposite signals.

In the represented example, a switch 720 couples the rail 702 to node N3 and a switch 718 couples the rail 704 to node N3. The switches 718 and 720 are for example controlled with opposite signals.

When the switches 710, 714 and 718 are in a conductive state and the switches 712, 716 and 720 are in a non-conductive state, the voltage V11 R2 is available to be applied to all of the input/outputs 108a, 108b, 108c. When the switches 710, 714 and 718 are in a non-conductive state and the switches 712, 716 and 720 are in a conductive state, the voltage V11 R1 is available to be applied to all of the input/outputs 108a, 108b, 108c.

In an example, the switches 710, 716 and 718 are in a conductive state and the switches 712, 714 and 720 are in a non-conductive state. In this case, the second voltage V11 R2 is available to be applied to the input/outputs 108a, 108c and the second voltage V11 R1 is available to be applied to the input/outputs 108b.

In a non-illustrated example, each of the input/output circuits 108a, 108b, 108c is surrounded by the three rails 702, 704, 706. In this case, the switches 710, 712 are coupled respectively to the respective rails surrounding the input/output circuits 108a, the switches 714, 716 are coupled respectively to the respective rails surrounding the input/output circuits 108b, and the switches 718, 720 are coupled respectively to the respective rails surrounding the input/output circuits 108c.

In the example of Figure 7a, the switches 710, 712, 714, 716, 718, and 720 are for example controlled by the controller 300. In another example, the switches 710, 712, 714, 716, 718, and 720 selection configuration is stored in a non-volatile memory such as an EEPROM or FLASH memory.

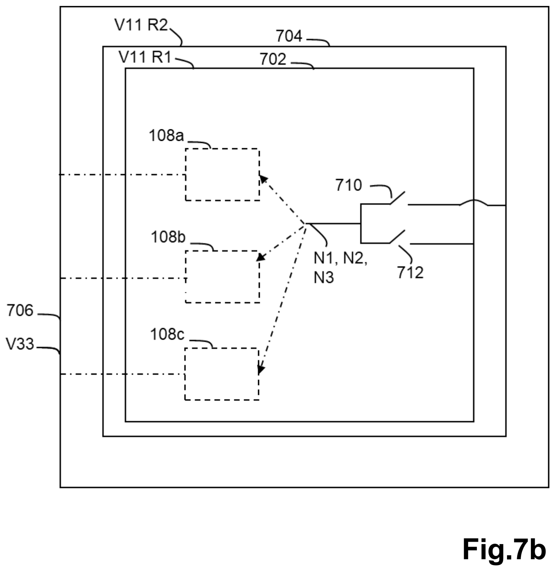

Figure 7b illustrates schematically blocks of Figure 1 according to an embodiment.

The example of Figure 7b applies to the examples of Figure 4 and 5. The example of Figure 7b is similar to the example of Figure 7a except that all nodes N1, N2, N3 are connected together and that the switches 710 and 712 are coupling respectively the common nodes N1, N2, N3 to the rail 704 and to the rail 702. In the example of Figure 7b, the switches 714, 716, 718, 720 are not present. In the example of Figure 7b, the switches 710, 712 are for example controlled by the controller 300.

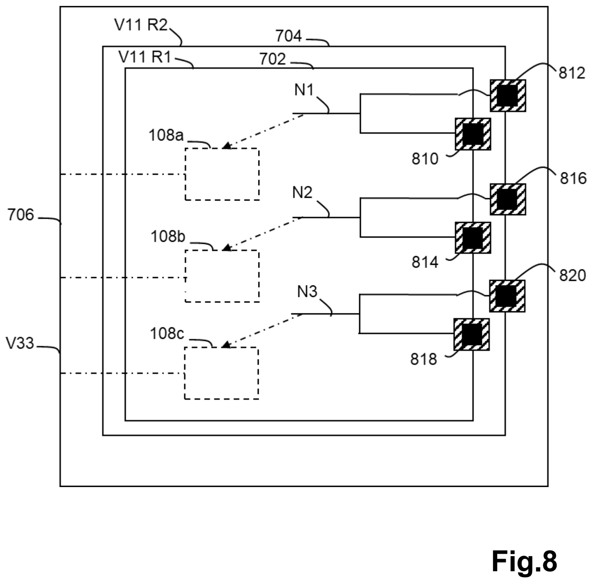

Figure 8 illustrates schematically blocks of Figure 1 according to an embodiment.

The example of Figure 8 is similar to the example of Figure 7a except that the connection between nodes N1, N2, N3 and the rails 702, 704 is conditioned by a hardware configuration instead of a state of conduction of switches.

In an example the connection between nodes N1, N2, N3 and the rails 702, 704 is conditioned by the presence or the absence of metal level parts, for example conductive vias or lines, 810, 812, 814, 816, 818, 816.

In another example, the connection between nodes N1, N2, N3 and the rails 702, 704 is conditioned by the state of fuses 810, 812, 814, 816, 818, 816. The fuses can be for example in a conductive state unless they are deactivated, or fused, by a laser beam or a local current burn for example.

In an example, when a vertical via 810 is present and a vertical via 812 is not present, the rail 702 is conductively coupled to node N1 and the second voltage V11 R1 is rendered available on node N1.

In another example, when a vertical via 816 is present and a vertical via 814 is not present, the rail 704 is conductively coupled to node N2 and the second voltage V11 R2 is rendered available on node N2.

In another example, when a fuse 818 is conductive and a fuse 820 has been fused, the rail 702 is conductively coupled to node N3 and the second voltage V11 R1 is rendered available on node N3.

The examples of Figures 7a, 7b and 8 offer flexibility for the user regarding which rail is connected to which input/output circuit 108a, 108b, 108c.

Various embodiments and variants have been described. Those skilled in the art will understand that certain features of these embodiments can be combined and other variants will readily occur to those skilled in the art. In particular, even if the examples of Figures 5 and 6 have exposed the cases of signals IO1_OKOUTV33, IO2_OKOUTV33, ION _OKOUTV33 being applied to a dedicated pin called 204, other pins of the input/output circuits 108a, 108b, 108c can be configured to, when receiving a signal for example similar to signal IO1_OKOUTV33 on a dedicated pin of their respective second stage 212, ground their respective output pin and/or to insulate the rail of application of the first voltage V33 from their respective output pin. Additionally, in the example of Figure 6, it is possible to save some power by only coupling the controller 300 to the inputs 204 of the respective input/output circuits 108a, 108b, 108c without controlling the switches 310, 312, 314 with the respective signals IO1_OKOUTV33, IO2_OKOUTV33, ION _OKOUTV33 controlling the inputs 204. In other words, in the example of Figure 6, the switches 310, 312 or 314 can be absent and the input/output circuits 108a, 108b, 108c controlled only by the respective signals IO1_OKOUTV33, IO2_OKOUTV33, ION_OKOUTV33.

Finally, the practical implementation of the embodiments and variants described herein is within the capabilities of those skilled in the art based on the functional description provided hereinabove. In particular, even if the examples show a controllable disconnection or connection, of the second stages 212 as regards to the rail 211 of application of the second voltage V11, the person of the art will use its knowledge to adapt this solution to the controllable disconnection or connection of the first stage as regards the rail 233 of application of the first voltage V33. Even if the description has been focused on outputting signals on the outputs IOFT1, IOFT2, IOFT3, the person of the art will adapt the control of the switches 310, 312, 314, 412 in the reverse case of signal sensing on the inputs IOFT1, IOFT2, IOFT3.

## Claims

1. A system on chip (100), comprising a controller (300) and one or several input/output circuits (108a, 108b, 108c), each of said circuits having:
- a first stage (214) and a second stage (212) operatively coupled to each other;
- said first stage (214) being configured to be powered by a first voltage (V33); and
- said second stage (212) being configured to be, controllably by the controller (300), powered by a second voltage (V11, V11 R1, V11 R2) different from first voltage (V33).

2. System on chip according to claim 1, wherein said first stage (214) is configured to control at least one output pin (IOFT1, IOFT2, IOFT3) of the respective input/output circuit (108a, 108b, 108c) according to a first signal state present on a first input (202) of the second stage (212).

3. System on chip according to claim 1 or 2, wherein said second stage (214) comprises a least one digital logic block.

4. System on chip according to any of claims 1 to 3, wherein said second stage (214) is configured to be coupled to at least one functionality block of the system on chip.

5. System on chip according to any of claims 1 to 4, wherein the system on chip comprises at least one voltage regulator configured to generate the second voltage (V11, V11 R1, V11 R2) from the first voltage (V33).

6. System on chip according to any of claims 1 to 5, wherein said one or several input/output circuits (108a, 108b, 108c) comprise, each, a first switch (310, 312, 314) coupling a respective node (N1, N2, N3) of application of the second voltage (V11, V11 R1, V11 R2) to the second stage (212) of the respective input/output circuit (108a, 108b, 108c);
each first switch (310, 312, 314) being configured to be controlled according to a respective input/output signal (I/O1, I/O2, I/ON) generated by the controller (300).

7. System on chip according to any of claims 1 to 5, wherein the system on chip (100) comprises at least one second switch (412) per said one or several input/output circuits (108a, 108b, 108c), each second switch (412) coupling a respective node (N1, N2, N3) of application of the second voltage (V11, V11 R1, V11 R2) to the second stage (212) of the respective input/output circuit (108a, 108b, 108c); each second switch (412) being configured to be controlled respectively by the controller (300).

8. System on chip according any of claims 1 to 5, wherein the system on chip comprises one second switch (412) per group of said one or several input/output circuits (108a, 108b, 108c);
said second switch (412) coupling a node (N1, N2, N3) of application of the second voltage (V11, V11 R1, V11 R2) to a node (NG) common to the second stages (212) of the input/output circuits (108a, 108b, 108c) of the group (420), wherein the input/output circuits (108a, 108b, 108c) of said group (420) for example participate to a same functionality, for example a bus communication functionality.

9. System on chip according to any of claims 2 to 7, wherein the second stage (212) of each of said one or several input/output circuits (108a, 108b, 108c) comprises a second input (204), each second input (204) of each of the input/output circuits (108a, 108b, 108c) being coupled, by a different conduction path, to the controller (300) ; each of said one or several input/output circuits (108a, 108b, 108c) being configured to insulate a rail (233, 706) of application of the first voltage (V33) from its respective output pin (IOFT1, IOFT2, IOFT3), and to ground the respective output pin (IOFT1, IOFT2, IOFT3), based on a respective second signal (IO1_OKOUTV33, IO2_OKOUTV33, ION_OKOUTV33) state present on the second input (204); the controller (300) being configured to control the said second signal state (IO1_OKOUTV33, IO2_OKOUTV33, ION_OKOUTV33) respectively for each of said one or several input/output circuits (108a, 108b, 108c).

10. System on chip according to claim 8, wherein the second stage (212) of said one or several input/output circuits (108a, 108b, 108c) comprises a second input (204) coupled to the controller (300);
each of said one or several input/output circuits (108a, 108b, 108c) of the group being configured to insulate a rail (233, 706) of application of the first voltage (V33) from its respective output pin (IOFT1, IOFT2, IOFT3), and to ground the respective output pin (IOFT1, IOFT2, IOFT3), based on a respective second signal (IO1_OKOUTV33, IO2_OKOUTV33, ION_OKOUTV33) state present on their second input (204) and common to all input/output circuits of the group;
the controller (300) being configured to control the said second signal (IO1_OKOUTV33, IO2_OKOUTV33, ION_OKOUTV33) state respectively for each different group of said one or several input/output circuits (108a, 108b, 108c), wherein said second switch (412) per group of input/output circuits (108a, 108b, 108c) is for example configured to be controlled based on the second signal (IO1_OKOUTV33, IO2_OKOUTV33, ION_OKOUTV33) state present on the second inputs (204) of the input/output circuits (108a, 108b, 108c) of said respective group.

11. System on chip according to claim 9 in its dependency to claim 6, wherein each first switch (310, 312, 314) is configured to be controlled based on the respective second signal state (IO1_OKOUTV33, IO2_OKOUTV33, ION_OKOUTV33) present on the second input (204) of the respective input/output circuit (108a, 108b, 108c).

12. System on chip according to any of claims 9 to 11, wherein the controller (300) is configured to control a state of each of the first or second switches (310, 312, 314, 412) according to a content of a configuration register.

13. System on chip according to any of claims 6, 7, 9, 11 or 12, wherein respective connection elements (710, 712, 714, 716, 718, 720, 810, 812, 814, 816, 818, 820) couple each of said nodes (N1, N2, N3) of application of the second voltage (V11, V11 R1, V11 R2) to a first and to a second rail (702, 704) ;
a state of each connection element (710, 712, 714, 716, 718, 720, 810, 812, 814, 816, 818, 820) defining which of the nodes (N1, N2, N3) of application of the second voltage (V11, V11 R1, V11 R2) are conductively coupled to the first rail (702) and which of the nodes (N1, N2, N3) of application of the second voltage (V11, V11 R1, V11 R2) are conductively coupled to the second rail (704);
said first and second rails (702, 704) being configured to receive respectively a voltage, equal or similar to the second voltage (V11, V11 R1, V11 R2), from different circuits.

14. System on chip according to claim 13, wherein:
said connection elements (710, 712, 714, 716, 718, 720) are switches controlled by said controller (300); or
said connection elements (810, 812, 814, 816, 818, 820) are metal level parts, the presence or the absence of said metal level parts defining which of the nodes (N1, N2, N3) of application of the second voltage (V11, V11 R1, V11 R2) are conductively coupled to the first rail (702) and which of the nodes (N1, N2, N3) of application of the second voltage (V11, V11 R1, V11 R2) are conductively coupled to the second rail (704); or
said connection elements (810, 812, 814, 816, 818, 820) are fuses, the fusing state of said fuses defining which of the nodes (N1, N2, N3) of application of the second voltage (V11, V11 R1, V11 R2) are conductively coupled to the first rail (702) and which of the nodes (N1, N2, N3) of application of the second voltage (V11, V11 R1, V11 R2) are conductively coupled to the second rail (704).

15. Device comprising a system on chip according to any of claims 1 to 14.
